# EUROPEAN PATENT APPLICATION

(11) **EP 3 531 443 A1**
(43) Date of publication of application: **28.08.2019**
(21) Application number: 18843669.5
(22) Date of filing: 11.10.2018
(51) Int. Cl.: H01L 21/67, H01L 25/16

(54) **BOARD-LEVEL ARCHITECTURE, PREPARATION METHOD THEREFOR, AND MOBILE TERMINAL**

(30) Priority: 11.08.2017 CN 201710685497
(71) Applicant: Huawei Technologies Co., Ltd., Longgang District Shenzhen, Guangdong 518129 (CN)
(72) Inventor: HE, Dapeng, Shenzhen Guangdong 518129 (CN)
(74) Representative: Pfenning, Meinig & Partner mbB
(86) International application number: PCT/CN2018/109821
(87) International publication number: WO 2019/029753

(57) **Abstract**

This application provides a board-level architecture. The board-level architecture includes: a first circuit board, a system-in-a-package module, at least one conductive terminal, and at least one first component. The system-in-a-package module is fastened on an upper surface of the first circuit board. The conductive terminal is located between a lower surface of the system-in-a-package module and the upper surface of the first circuit board, and the conductive terminal is separately electrically connected to the system-in-a-package module and the first circuit board. The first component is fastened on the upper surface of the first circuit board, and the first component is located in a region between the lower surface of the system-in-a-package module and the upper surface of the first circuit board. In the foregoing technical solution, when the system-in-a-package module is connected to the first circuit board, an accommodation space is formed between the system-in-a-package module and the first circuit board, so that the relatively small first component can be placed in the accommodation space to reduce an area occupied by components on the first circuit board, thereby reducing a size of the board-level architecture, and facilitating miniaturization development of the board-level architecture.

## Description

### TECHNICAL FIELD

This application relates to the field of mobile terminal technologies, and in particular, to a board-level architecture, a method for manufacturing a board-level architecture, and a mobile terminal.

### BACKGROUND

A current mobile phone motherboard is implemented by soldering components of different sizes to a surface of a circuit board and performing mounting by using a surface mount technology (Surface Mount Technology, SMT). However, a miniaturization requirement for consumer electronics is quite urgent. Therefore, reduction on an area/a size of the circuit board becomes a development direction.

As one of technical development directions in a miniaturization technology, modularization is integrating circuits each having a particular function into a system-in-a-package (System-In-a-Package, SIP) module. According to a SIP module technology, a product size and thickness can be effectively reduced. The SIP module technology has great application space especially in a scenario with a quite urgent miniaturization requirement for terminal products.

Most package forms of current SIP modules are forms such as a ball grid array (Ball Grid Array, BGA) package form or a land grid array (land grid array, LGA) package form, so that a module can be mounted on a board by using the SMT.

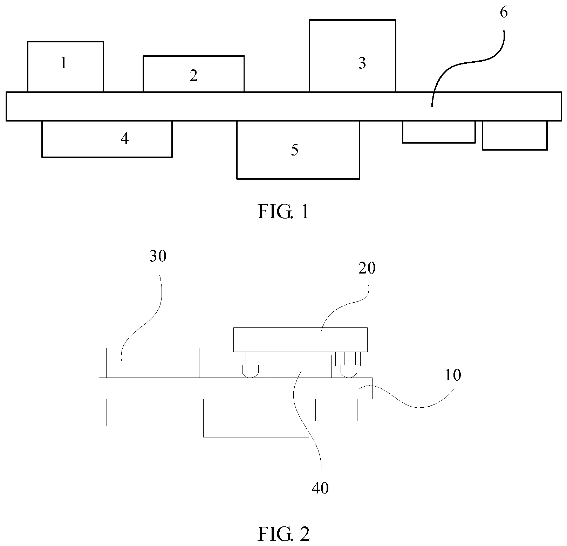

As shown in FIG. 1, during product implementation, a plurality of components may be integrated into one SIP module. In FIG. 1, a component 1 to a component 5 are disposed, in a parallel layout, on a circuit board 6. A board layout area cannot be reduced. However, some components have a relatively small height, and a space above the low components is wasted. Consequently, a board-level architecture cannot be miniaturized.

### SUMMARY

This application provides a board-level architecture, to improve miniaturization development of the board-level architecture.

This application provides a board-level architecture. The board-level architecture includes: a first circuit board, a system-in-a-package module, at least one conductive terminal, and at least one first component. The system-in-a-package module is fastened on an upper surface of the first circuit board, a lower surface of the system-in-a-package module faces the upper surface of the first circuit board, and a vertical projection of the system-in-a-package module on the upper surface of the first circuit board along a thickness direction of the first circuit board is located within the upper surface of the first circuit board.

The conductive terminal is located between the lower surface of the system-in-a-package module and the upper surface of the first circuit board, and one end of the conductive terminal is electrically connected to the lower surface of the system-in-a-package module, and the other end is electrically connected to the upper surface of the first circuit board.

The first component is fastened on the upper surface of the first circuit board, and the first component is located in a region between the lower surface of the system-in-a-package module and the upper surface of the first circuit board. The first component is isolated from the conductive terminal.

In the foregoing technical solution, the conductive terminal is configured to fasten the system-in-a-package module on the upper surface of the first circuit board and support the system-in-a-package module, and configured to implement signal transmission between the system-in-a-package module and the first circuit board. A plurality of components are packaged by using the system-in-a-package module to be connected to the first circuit board, so that spaces occupied by the components can be effectively integrated. In addition, when the system-in-a-package module is connected to the first circuit board, an accommodation space is formed between the system-in-a-package module and the first circuit board, so that the relatively small first component can be placed in the accommodation space to stack, on the first circuit board, components laid flat on the first circuit board in the prior art, to reduce an area occupied by the components on the first circuit board, thereby reducing a size of the board-level architecture, and facilitating miniaturization development of the board-level architecture.

Optionally, the board-level architecture further includes a third component, the third component is disposed on the first circuit board and located outside the accommodation space, and a height of the third component is greater than a height of the first component. In this way, a space on the board-level architecture can be properly utilized, to facilitate miniaturization development of the board-level architecture.

With reference to the first aspect, in a first specific implementation solution, the system-in-a-package module includes a second circuit board, a plastic package body, and at least two second components, each second component is fastened on an upper surface of the second circuit board, every two second components are isolated from each other, at least a side surface of each second component is wrapped by the plastic package body, and a vertical projection of the second circuit board on the upper surface of the first circuit board along the thickness direction of the first circuit board is located within the upper surface of the first circuit board.

Optionally, both the side surfaces of each component and an upper surface, away from the second circuit board, of each component are wrapped by the plastic package body. It should be noted that, a surface, in contact with the upper surface of the second circuit board, of the second component is a lower surface of the second component, and the lower surface of the second component is away from an upper surface of the second component.

With reference to the first aspect or the first specific implementation solution of the first aspect, in a second specific implementation solution, the one end of the conductive terminal is electrically connected to a lower surface of the second circuit board, and the lower surface of the second circuit board is away from the upper surface of the second circuit board. In this way, the conductive terminal is separately electrically connected to the first circuit board and the system-in-a-package module.

With reference to the second specific implementation solution of the first aspect, in a third specific implementation solution, the other end of the conductive terminal is electrically connected to the upper surface of the first circuit board by using a first solder ball.

With reference to the first aspect or any one of the first to third specific implementation solutions of the first aspect, in a fourth specific implementation solution, the conductive terminal is a conductive column or a second solder ball. The conductive terminal is formed by using different conductive structures.

With reference to any one of the second to fourth specific implementation solutions of the first aspect, in a fifth specific implementation solution, a side surface of the conductive terminal is wrapped by a plastic package layer. Compared with the conductive terminal that is not wrapped by the plastic package layer, the conductive terminal wrapped by the plastic package layer has a longer sectional perimeter and a larger sectional area. Therefore, the conductive terminal wrapped by the plastic package layer can better support the system-in-a-package module. It should be noted that, a sectional plane of the conductive terminal is parallel with the upper surface of the first circuit board.

With reference to any one of the second to fourth specific implementation solutions of the first aspect, in a sixth specific implementation solution, the board-level architecture further includes a third circuit board, and the third circuit board is located between the first circuit board and the second circuit board. A vertical projection of the third circuit board on the lower surface of the second circuit board along a thickness direction of the third circuit board is located within the lower surface of the second circuit board. The third circuit board has a through hole, and the conductive terminal passes through the through hole. In addition, during specific disposition, a vertical projection of the third circuit board on a plane on which the lower surface of the second circuit board is located is located within a vertical projection of the second circuit board on the plane. In this way, the disposed third circuit board does not additionally occupy an area of the upper surface of the first circuit board. In addition, the conductive terminal can be protected by using the third circuit board, to improve a support effect of the conductive terminal.

With reference to any one of the first to sixth specific implementation solutions of the first aspect, in a seventh specific implementation solution, there are two or more conductive terminals. At least one of the two or more conductive terminals is electrically connected to a first edge of the lower surface of the second circuit board. At least one of the two or more conductive terminals is electrically connected to a second edge of the lower surface of the second circuit board. The first edge is opposite or adjacent to the second edge. In this way, it is ensured that the conductive terminals can stably support the system-in-a-package module.

With reference to any one of the first to seventh specific implementation solutions of the first aspect, in an eighth specific implementation solution, the system-in-a-package module further includes a metal shielding can wrapping the plastic package body, and the metal shielding can is connected to a ground cable of the second circuit board. An electromagnetic isolation effect of the second components in the system-in-a-package module is improved, thereby improving a work effect of the second components.

With reference to the eighth specific implementation solution of the first aspect, in a ninth specific implementation solution, at least one isolating layer is inserted in the plastic package body, and the at least one isolating layer divides the metal shielding can into at least two metal shielding spaces. The isolating layer is a conductor, both an upper surface and side surfaces of the isolating layer are electrically connected to the metal shielding can, a lower surface of the isolating layer is electrically connected to the ground cable of the second circuit board, and the upper surface and the lower surface of the isolating layer are opposite. There are a plurality of second components, and each metal shielding space has at least one second component inside. During specific disposition, both the upper surface and the side surfaces of the isolating layer are in contact with the metal shielding can, and the lower surface of the isolating layer is in contact with the ground cable of the second circuit board. An electromagnetic isolation effect of the second components in the system-in-a-package module is improved, thereby improving a work effect of the second components.

Optionally, the isolating layer is a metal sheet, and one end of the metal sheet is electrically connected to the metal shielding can, and the other end is electrically connected to a solder pad that is on the second circuit board and that is connected to the ground cable. The metal sheet is used as the isolating layer, and when the metal sheet is soldered to the solder pad connected to the ground cable, the metal sheet can be well soldered with residual solder in the solder pad, to ensure a ground effect of the isolating layer.

Optionally, the isolating layer includes a metal sheet and a cured conductive material on the metal sheet. A lower surface of the metal sheet is in contact with the upper surface of the second circuit board, and the lower surface of the metal sheet is electrically connected to the ground cable located on the upper surface of the second circuit board. The conductive material is electrically connected to the metal shielding can. Specifically, when a gap exists between an upper surface of the metal sheet and an inner surface of the metal shielding can, a conductive material such as silver paste may be applied on the upper surface of the metal sheet, to fill the gap between the upper surface of the metal sheet and the inner surface of the metal shielding can. After the conductive material is cured, the cured conductive material is formed, so that the upper surface of the metal sheet can be electrically connected to the inner surface of the metal shielding can by using the cured conductive material. When the metal sheet is soldered to a solder pad connected to the ground cable, the metal sheet can be well soldered with residual solder in the solder pad, to ensure a ground effect of the isolating layer.

According to a second aspect, a method for manufacturing a board-level architecture is provided. The board-level architecture is the board-level architecture described above, and the method includes the following steps:
disposing at least one first component on an upper surface of a first circuit board;
connecting a conductive terminal onto a system-in-a-package module, where the conductive terminal is electrically connected to a lower surface of the system-in-a-package module; and
electrically connecting the conductive terminal to the upper surface of the first circuit board, where the at least one first component is isolated from the conductive terminal during connection; and when the conductive terminal is connected to the first circuit board, a vertical projection of the system-in-a-package module on the upper surface of the first circuit board along a thickness direction of the first circuit board is located within the upper surface of the first circuit board, and the first component disposed on the upper surface of the first circuit board is located in a region between the lower surface of the system-in-a-package module and the upper surface of the first circuit board.

In the foregoing technical solution, a plurality of components are packaged by using the system-in-a-package module to be connected to the first circuit board, so that spaces occupied by the components can be effectively integrated. In addition, when the system-in-a-package module is connected to the first circuit board, an accommodation space is formed between the system-in-a-package module and the first circuit board, so that the relatively small first component can be placed in the accommodation space, to stack, on the first board-level architecture, components laid flat on the first circuit board in the prior art, to reduce an area occupied by the components on the first circuit board, thereby reducing a size of the board-level architecture, and facilitating miniaturization development of the board-level architecture.

With reference to the second aspect, in a first specific implementation solution, the method further includes manufacturing the system-in-a-package module, and the manufacturing the system-in-a-package module includes the following steps:
disposing at least two second components on a second circuit board, where every two second components are isolated from each other, and a vertical projection of the second circuit board on the upper surface of the first circuit board along the thickness direction of the first circuit board is located within the upper surface of the first circuit board; and
packaging at least a side surface of each second component by using a plastic package body.

With reference to the second aspect, in a second specific implementation solution, the method further includes wrapping a side surface of the conductive terminal by using a plastic package layer; or
disposing a third circuit board on the upper surface of the first circuit board, where the third circuit board has a through hole, the disposed conductive terminal passes through the through hole, and a vertical projection of the disposed third circuit board on a lower surface of the second circuit board is located within the lower surface of the second circuit board.

With reference to the first or second specific implementation solution of the second aspect, in a third specific implementation solution, the manufacturing the system-in-a-package module further includes the following step:
wrapping the formed plastic package body by using a metal shielding can, where the metal shielding can is electrically connected to a ground cable of the second circuit board.

With reference to the third specific implementation solution of the second aspect, in a fourth specific implementation solution, the manufacturing the system-in-a-package module further includes the following step:
forming at least one isolating layer inserted in the plastic package body, where the at least one isolating layer divides the metal shielding can into at least two metal shielding spaces, the isolating layer is a conductor, both an upper surface and side surfaces of the isolating layer are electrically connected to the metal shielding can, a lower surface of the isolating layer is electrically connected to the ground cable of the second circuit board, the upper surface and the lower surface of the isolating layer are opposite, there are a plurality of second components, and each metal shielding space has at least one second component inside.

Specific manufacturing of the isolating layer includes the following steps:
soldering a metal sheet to a solder pad connected to the ground cable of the second circuit board;
forming the plastic package body, where the plastic package body wraps the metal sheet;
opening a slot in the plastic package body to expose the metal sheet; and
pouring silver paste into the opened slot to form a conductive material connected to the metal sheet, so that the metal sheet and the conductive material form the isolating layer, so as to further improve an isolated ground effect of the isolating layer, thereby improving an electromagnetic isolation effect.

### BRIEF DESCRIPTION OF DRAWINGS

FIG. 1 is a schematic structural diagram of a board-level architecture in the prior art;
FIG. 2 is a schematic structural diagram of a board-level architecture according to an embodiment of this application;
FIG. 3 is a schematic structural diagram of another board-level architecture according to an embodiment of this application;
FIG. 4 is a schematic structural diagram of a system-in-a-package module of the board-level architecture shown in FIG. 3;
FIG. 5 is a schematic structural diagram of conductive terminals of the system-in-a-package module shown in FIG. 4;
FIG. 6 is another schematic structural diagram of conductive terminals according to this application;
FIG. 7 is a schematic structural diagram of another board-level architecture according to an embodiment of this application;
FIG. 8 is a schematic structural diagram of a system-in-a-package module of the board-level architecture shown in FIG. 7;
FIG. 9 is a schematic structural diagram of conductive terminals of the system-in-a-package module shown in FIG. 8;
FIG. 10 is a cutaway drawing of a system-in-a-package module according to an embodiment of this application;
FIG. 11 is a cutaway drawing of another system-in-a-package module according to an embodiment of this application; and
FIG. 12 is a top view of a system-in-a-package module according to an embodiment of this application.

### DESCRIPTION OF EMBODIMENTS

To make the objectives, technical solutions, and advantages of this application clearer, the following further describes this application in detail with reference to the accompanying drawings.

First, a structure of a board-level architecture in the prior art is described. As shown in FIG. 1, the board-level architecture in the prior art is implemented by laying flat a plurality of components on two sides of a circuit board. For example, a component 1, a component 2, a component 3, a component 4, a component 5, and another component are all disposed on the circuit board in a laid flat manner, causing a relatively large size of the entire board-level architecture. To further reduce an area occupied by the board-level architecture, this application provides a board-level architecture, in which a SIP module and another component are disposed in a stacked manner, to reduce an area occupied by the board-level architecture. The board-level architecture provided in the embodiments of this application is described below in detail with reference to the accompanying drawings.

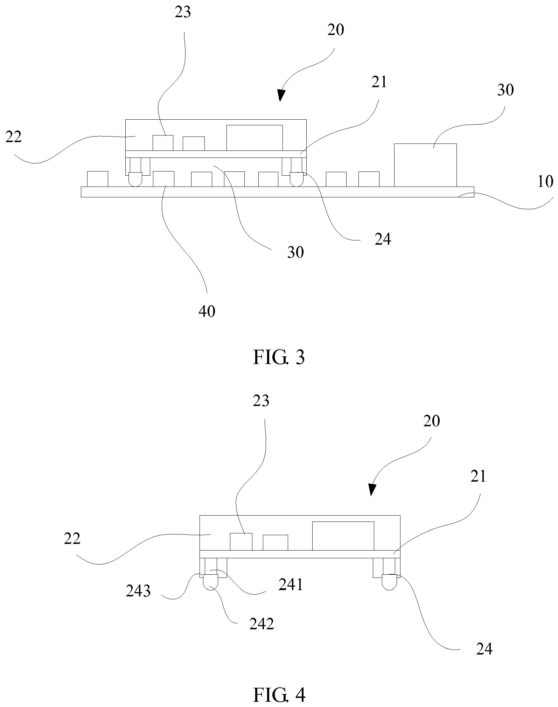

FIG. 2 is a schematic structural diagram of a board-level architecture according to an embodiment of this application. FIG. 3 is a schematic structural diagram of another board-level architecture according to an embodiment of this application. It can be learned with reference to FIG. 2 that, the board-level architecture provided in this application includes components such as a first circuit board 10, a system-in-a-package module 20, at least one conductive terminal 24, and at least one first component 40. To conveniently describe a relative location relationship between components, meanings of an upper surface and a lower surface are defined below by using a board-level architecture placement direction shown in FIG. 2 as a reference direction. The upper surface is a surface, facing upward, of a component. The lower surface is a surface, facing downward, of a component. When two components are stacked along a vertical direction, a lower surface of an upper component and an upper surface of a lower component are two surfaces facing each other.

During specific disposition, the system-in-a-package module 20 is fastened on an upper surface of the first circuit board 10, the system-in-a-package module 20 and the first circuit board 10 are stacked along the vertical direction, a lower surface of the system-in-a-package module 20 faces the upper surface of the first circuit board 10, and a vertical projection of the system-in-a-package module 20 on the upper surface of the first circuit board 10 along a thickness direction of the first circuit board 10, namely, a vertical direction in FIG. 2, is located within the upper surface of the first circuit board 10. When the system-in-a-package module 20 is specifically disposed, the conductive terminal 24 is located between the lower surface of the system-in-a-package module 20 and the upper surface of the first circuit board 10, and one end of the conductive terminal 24 is electrically connected to the lower surface of the system-in-a-package module 20, and the other end is electrically connected to the upper surface of the first circuit board 10. In other words, the system-in-a-package module 20 is fastened on the first circuit board 10 by using the conductive terminal 24. Specifically, the conductive terminal 24 functions as a structure connecting piece for fastening the system-in-a-package module 20 on the first circuit board 10, to support the system-in-a-package module 20, and also functions as a connecting piece for signal transmission between the system-in-a-package module 20 and the first circuit board 10, to implement signal transmission between the system-in-a-package module 20 and the first circuit board 10. In addition, during disposition, an accommodation space 50 is enclosed by the conductive terminal 24, the first circuit board 10, and the system-in-a-package module 20.

The first component 40 is fastened on the upper surface of the first circuit board 10, and the first component 40 is located in a region between the lower surface of the system-in-a-package module 20 and the upper surface of the first circuit board 10, namely, the accommodation space 50. To ensure that the first component 40 can be disposed between the first circuit board 10 and the system-in-a-package module 20, in a height direction, a distance between the lower surface of the system-in-a-package module 20 and the upper surface of the first circuit board 10 is greater than or equal to a height of the first component 40. The height direction is an extension direction of a straight line perpendicular to a plane on which the upper surface of the first circuit board 10 is located.

In addition, during specific disposition, the first component 40 is isolated from the conductive terminal 24. The "isolated" means that the first component 40 is not in contact with the conductive terminal 24, and no signal is transmitted between the first component 40 and the conductive terminal 24. In this way, a good isolation effect between the first component 40 and the system-in-a-package module 20 is ensured, to ensure that components can stably work.

In addition, the board-level architecture provided in this embodiment of this application may further include a third component 30. The third component 30 is disposed on the first circuit board 10 and located outside the accommodation space 50. As shown in FIG. 2, a height of the third component 30 is greater than the height of the first component 40. During specific disposition, the first component 40 and the third component 30 are disposed on the first circuit board 10, the system-in-a-package module 20 is also disposed on the first circuit board 10, and the system-in-a-package module 20 is disposed above the first component 40. In this way, a space above the first component 40 is properly utilized, to reduce a size of the board-level architecture, reduce an area occupied by the board-level architecture, and facilitate miniaturization development of the board-level architecture.

It should be noted that, the foregoing thickness is a thickness of the first circuit board in the vertical direction, and may be understood as a height of the first circuit board in a placement direction of the first circuit board shown in FIG. 2.

It should be understood that, although FIG. 2 shows only one first component 40 and one third component 30, the first component 40 and the third component 30 are located on a same side of the first circuit board 10, and the system-in-a-package module 20 and the first component 40 are stacked on the side, it can be learned from FIG. 2 that, the first component 40 has a relatively small height, after the system-in-a-package module 20 is stacked, an overall increase in height is limited, the system-in-a-package module 20 and the first component 40 are stacked in the height direction, and during specific disposition, the vertical projection of the system-in-a-package module on the upper surface of the first circuit board is located within the upper surface of the first circuit board, in other words, when disposed, the system-in-a-package module does not protrude beyond the first circuit board (in a horizontal direction). Therefore, compared with a manner in which both the system-in-a-package module 20 and the first component 40 are laid flat on a surface of the first circuit board 10, the solution provided in this application can be used to reduce an area occupied on the surface of the first circuit board 10 by a plurality of components disposed on the first circuit board 10. In addition, to properly utilize a space of the first circuit board 10, another component (not labeled in the figure) may be further disposed on a side, away from the third component 30, of the first circuit board 10, to properly utilize the space of the first circuit board 10, thereby reducing an area of the first circuit board 10.

During specific disposition, the system-in-a-package module 20 provided in this embodiment of this application may be implemented by using different solutions. However, regardless of which solution is used, the system-in-a-package module 20 includes components such as a second circuit board 21, a plastic package body 22, and at least two second components 23. During specific disposition, each second component 23 is fastened on an upper surface of the second circuit board 21, namely, a surface, away from the first circuit board 10, of the second circuit board 21 shown in FIG. 2. In addition, during specific disposition, every two second components 23 are isolated from each other, to ensure that the second components 23 can stably work. In addition, to improve safety of the second components 23, at least a side surface of each second component 23 is wrapped by the plastic package body 22. A vertical projection of the second circuit board 21 on the upper surface of the first circuit board 10 along the thickness direction of the first circuit board 10 is located within the upper surface of the first circuit board 10, so that as described above, the system-in-a-package module does not protrude beyond the first circuit board 10 in the horizontal direction, thereby avoiding that the area occupied by the first circuit board 10 is increased due to the disposed system-in-a-package module.

To conveniently understand a manner that is for connecting the system-in-a-package module and the first circuit board 10 and that is provided in this embodiment, manners for connecting the first circuit board 10 and system-in-a-package modules 20 in three different solutions are enumerated. The following describes in detail the three different solutions of the system-in-a-package module 20 that are provided in the embodiments of this application.

First, several basic concepts are described.

Injection molding (Injection Molding) is placing a printed circuit board (Printed Circuit Board, PCB) or a carrier board on which a component is mounted and/or that has a board-level architecture, into an injection molding machine, wrapping the entire PCB and the component on the PCB by using a thermoset plastic material (whose main component is epoxy resin), performing preliminary curing and molding in a high-temperature vacuum environment, and then taking out the PCB and the component on the PCB for high-temperature baking until they are completely cured, to form a black component common in the electronics industry. An injection molding process may be roughly divided into the following stages: mold clamping, injection, pressure holding, cooling, mold opening, product removal, and baking.

A lower surface (also referred to as a "bottom surface") of a module is a surface, connected to a subsequent mounted PCB, of the module, and an input/output (Input/Output, I/O) terminal is disposed on the surface to implement soldering to the PCB. In this application, as shown in FIG. 3, the bottom surface is a surface that is of the second circuit board 21 and on which the conductive terminal 24 is disposed.

An upper surface (also referred to as a "top surface") of a module is a surface, opposite to the bottom surface of the module, of the module on a PCB or a carrier board. In this application, as shown in FIG. 4, the top surface is a surface that is of the second circuit board 21 and on which the second components 23 are disposed.

Underfill (Underfill) is a relatively popular manner at present, in which dispensing is mainly performed through "non-contact jet". The non-contact jet dispensing technology is an optimum method for underfill of a chip scale package (CSP) or a ball grid array (BGA) on a circuit board. When underfill is performed to seal a solder joint, a CSP component has better reliability when used in a portable electronic device.

Ball grid array (Ball Grid Array, BGA) packaging is fabricating an array solder ball on a bottom of a substrate of a package body as an I/O terminal of a circuit to interconnect with a PCB. A component packaged by using the technology is a surface mount device.

A main body of a package body of land grid array (Land Grid Array, LGA) packaging is the same as that of the BGA packaging. A difference lies in that, in the BGA packaging, a solder ball is prefabricated on a solder pad 211 for SMT soldering, while in the LGA packaging, a bottom solder pad 211 is directly retained and directly mounted on a PCB. A bottom of the package is a PCB carrier board, and the bottom solder pad 211 is basically aligned with the component package body.
Solution 1: The top surface and the bottom surface of the module are partially packaged to form, on the second circuit board 21, the plastic package body 22 packaging the second components 23 and a plastic package layer 243 packaging a conductive column 241. The conductive column 241 is one-to-one correspondingly connected to an I/O terminal on the second circuit board 21, and extends outside the plastic package layer 243. The conductive column 241 is connected to the first circuit board 10 to implement LGA-like packaging. Alternatively, a first solder ball 242 is soldered to the conductive column 241, and the first solder ball 242 is connected to the first circuit board 10, to implement BGA-like packaging. A material of the conductive column 241 may be metal such as a copper column, or nonmetal; or may be a non-conductive material whose surface has a solderable coating, or a metal material. The conductive column 241 may be discrete, or may be integrated. For example, the conductive column 241 may be an integrated PCB. In addition, during packaging, a non-I/O terminal region on the bottom surface is not packaged, so that the accommodation space 50 is enclosed by plastic package layers 243 to form a partial concave cavity on the bottom surface of the module, to accommodate the first component 40.
Solution 2: The top surface and the bottom surface of the module are partially packaged, and a non-I/O terminal region on the bottom surface is not packaged, to form a partial concave cavity on the bottom surface. The packaging manner is the same as that in the module solution 1, and details are not described herein again. In this solution, an I/O terminal that is within packaging coverage of the bottom surface and that is on the first circuit board 10 extends to a packaging surface of the bottom surface by using a second solder ball 245, and is connected to the first circuit board 10, to implement LGA-like packaging. Alternatively, a first solder ball 242 is disposed at a location of a second solder ball 245, and an I/O terminal that is within packaging coverage of the bottom surface and that is on the first circuit board 10 is connected to the first circuit board 10 by using the first solder ball 242, to implement BGA-like packaging.
Solution 3: The top surface of the module is soldered to the second components 23, a conductive column 241 can be connected to an I/O terminal on the bottom surface (an I/O terminal of the second circuit board 21) through soldering, and in an I/O terminal region, the conductive column 241 and a solder joint between the conductive column 241 and a back surface of the PCB are wrapped by using a packaging material or an underfill material. A height of the wrapping material is less than a height of the conductive column 241, to partially expose the conductive column 241 and form a partial concave cavity on the bottom surface. The conductive column 241 is connected to the first circuit board 10 to implement QFN-like packaging. Alternatively, a first solder ball 242 is disposed at a location of the conductive column 241, and the conductive column 241 is connected to the first circuit board 10 by using the first solder ball 242, to implement BGA-like packaging. A material of a conductor terminal of the conductive column 241 may be metal such as a copper column, or nonmetal; or may be a non-conductive material whose surface has a solderable coating, or a metal material. The conductor terminal may be discrete or integrated. For example, the conductor terminal may be an integrated PCB.

It can be learned from the module solution 1, the module solution 2, and the module solution 3 that, the conductive terminal 24 provided in this application includes a plurality of conductive terminals electrically connected to the second circuit board 21, and the conductive terminals are configured to connect to I/O terminals on the second circuit board 21. Each conductive terminal is further electrically connected to the first circuit board 10. During specific connection, the conductive terminals may be electrically connected to the first circuit board 10 directly. Alternatively, the first solder ball 242 may be disposed on each conductive terminal, and each conductive terminal is electrically connected to the first circuit board 10 by using the corresponding first solder ball 242. In addition, during specific disposition, the conductive terminals may be conductive columns 241 (in the module solution 1 and the module solution 3) or second solder balls 245 (in the module solution 2). In addition, to improve a support effect to ensure stability of the system-in-a-package module 20, in this application, the conductive terminals 24 further include the plastic package layer 243. The plastic package layer 243 is configured to wrap the conductive terminals (the conductive columns 241 or the second solder balls 245) to protect the conductive terminals, and configured to enhance a support capability of the conductive terminals 24. In addition, in addition to the foregoing described manner of using the plastic package layer 243, a manner of using a circuit board may be selected. For example, the conductive terminals 24 further include a third circuit board 244, and the third circuit board 244 is provided with through holes for accommodating the conductive terminals. The third circuit board 244 is configured to protect the conductive terminals, and enhance a support capability of the conductive terminals 24.

When the conductive terminals 24 are formed, the conductive terminals 24 need to be capable of stably supporting the second circuit board 21 and the second components 23 disposed on the second circuit board 21. During specific disposition, there are two or more conductive terminals 24, at least one of the two or more conductive terminals 24 is electrically connected to a first edge of the lower surface of the second circuit board, at least one of the two or more conductive terminals 24 is electrically connected to a second edge of the lower surface of the second circuit board, and the first edge is opposite or adjacent to the second edge. For example, the conductive terminals 24 support at least two edges of the second circuit board 21. In addition, to further improve a support effect of the conductive terminal 24, for example, a side surface of the conductive terminal 24 is wrapped by the plastic package layer 243. Compared with the conductive terminal 24 that is not wrapped by the plastic package layer 243, the conductive terminal 24 wrapped by the plastic package layer 243 has a longer sectional perimeter and a larger sectional area. Therefore, the conductive terminal 24 wrapped by the plastic package layer 243 can better support the system-in-a-package module. It should be noted that, a sectional plane of the conductive terminal 24 is parallel with the upper surface of the first circuit board 10. Alternatively, the conductive terminal 24 is supported by using the third circuit board 244. Specifically, the third circuit board 244 is further included, and the third circuit board 244 is located between the first circuit board 1010 and the second circuit board 21. A vertical projection of the third circuit board 244 on the lower surface of the second circuit board 21 along a thickness direction of the third circuit board 244 is located within the lower surface of the second circuit board 21. The third circuit board 244 has a through hole, and the conductive terminal 24 passes through the through hole. In addition, during specific disposition, a vertical projection of the third circuit board 244 on a plane on which the lower surface of the second circuit board 21 is located is located within a vertical projection of the second circuit board 21 on the plane. In this way, the disposed third circuit board 244 does not additionally occupy an area of the upper surface of the first circuit board 10. In addition, the conductive terminal 24 can be protected by using the third circuit board 244, to improve the support effect of the conductive terminal 24.

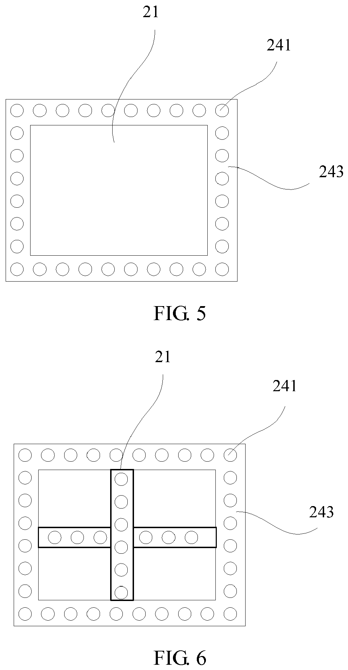

It can be learned from the foregoing description that, during specific support, the conductive terminals 24 may support two edges, three edges, or four edges of the second circuit board 21. When supporting two adjacent edges (the first edge is adjacent to the second edge), the conductive terminals 24 may be in an "L" shape. When supporting two opposite edges (the first edge is opposite to the second edge), two conductive terminals 24 are two opposite strips. As shown in FIG. 2, the conductive terminals 24 support two opposite edges of the second circuit board 21. When supporting three edges, the conductive terminals 24 are in a "U" shape. When supporting four edges, the conductive terminals 24 are in a frame shape. For a specific shape, refer to FIG. 5.

The following describes, in detail with reference to the accompanying drawings, the manners for connecting the first circuit board 10 and the system-in-a-package module 20 in three different manners.

### Embodiment 1

First, it should be noted that, a conductive terminal 24 appears in this embodiment as a part of structure of the system-in-a-package module 20. In addition, in this embodiment of this application, a first circuit board 10, a second circuit board 21, and a third circuit board 244 all are printed circuit boards. FIG. 3 is a schematic structural diagram of a board-level architecture according to this embodiment. FIG. 4 is a schematic structural diagram of a system-in-a-package module 20 of the board-level architecture. FIG. 5 is a schematic structural diagram of a support layer of the system-in-a-package module 20. FIG. 6 is another schematic structural diagram of conductive terminals 24 according to this application.

### (1) Module packaging structure and implementation thereof

A second component 23 is mounted on a top surface of the second circuit board 21. A quantity of second components 23 may be determined based on a requirement. There may be one second component 23, or may be two or more second components 23, which may be specifically determined based on an actual case. Further, a component may also be mounted on a bottom surface of the second circuit board 21. Components are disposed on the two surfaces of the second circuit board 21, to reduce an area occupied by the components on the surfaces of the second circuit board 21.

In addition, the top surface of the second circuit board 21 is packaged to form a plastic package body 22 wrapping the second component 23. Further, a conductive column 241 connected to an I/O terminal on the second circuit board 21 is packaged to form a plastic package layer 243 wrapping the conductive column 241. When the plastic package body 22 and the plastic package layer 243 are formed, entire packaging or partial packaging may be performed, provided that the second component 23 and the conductive column 241 can be wrapped. In addition, during specific disposition, a non-I/O terminal region on the bottom surface of the second circuit board 21 is not packaged, so that a space for accommodating a first component 40 is enclosed by two adjacent plastic package layers 243 and a region that is on the bottom surface of the second circuit board 21 and that is located between the two adjacent plastic package layers 243. In other words, when the system-in-a-package module 20 is formed, a partial concave (or a "concave cavity") structure is formed on a surface of the module. A depth of the concave cavity relative to the first circuit board 10 is 0.8 mm to 3 mm.

When the conductive column 241 is specifically disposed, an I/O terminal within packaging coverage of the bottom surface is connected to the conductive column 241 through soldering, and the conductive column 241 extends to a packaging surface of the bottom surface (a surface of the plastic package layer 243), to implement M-LGA packaging. In this case, the conductive column 241 is electrically connected to the first circuit board 10 directly. Alternatively, a first solder ball 242 is disposed at a soldering end location of the conductive column 241 to implement M-BGA packaging (as shown in FIG. 4 and FIG. 3). In this case, the system-in-a-package module 20 is connected to the first circuit board 10 by using the first solder ball 242.

During specific disposition, the conductive column 241 may be discrete, and a material of the conductive column 241 may be metal such as a copper column, or nonmetal; or may be a non-conductive material whose surface has a solderable coating, such as an LCP, or a metal material such as aluminum, nickel, or iron. A shape of the conductive column 241 may be a cylinder (whose bottom view is shown in FIG. 5). Alternatively, the conductive column 241 is a prism whose cross section is a polygon, for example, a polyhedral prism such as a quadrangular prism, a pentagonal prism, or a hexagonal prism.

During specific disposition, conductive columns 241 may be arranged in one or more rows, or arranged randomly. FIG. 5 shows a one-row arrangement manner, and conductive terminals 24 support four edges of the second circuit board 21. In this case, one concave cavity is formed. As shown in FIG. 6, the conductive columns 241 are arranged in a plurality of rows, and four concave cavities are formed by using the plurality of rows of conductive columns 241. It should be understood that, FIG. 6 shows only an example in which a plurality of concave cavities can be formed, and different quantities of concave cavities such as five concave cavities or six different concave cavities may alternatively be formed.

The conductive columns 241 may be partially integrated, to divide I/O terminals of the second circuit board 21 into a plurality of parts. For example, a material such as a PCB, an LCP, or a PI is used as a substrate, and circuit processing is performed on the substrate to connect I/O terminals. A partial integrated design solution is used for integrated I/O terminals. After processing is completed, the PCB is cut into single strips, and is entirely soldered to the bottom surface of the second circuit board 21 of the module.

In addition, the conductive columns 241 may be integrated. In this case, the conductive terminals 24 further include the third circuit board 244, and the third circuit board 244 is provided with through holes for accommodating the conductive terminals. The integrated conductive columns 241 are first processed on the third circuit board 244 as a whole, and then wholly soldered to the bottom surface of the first circuit board 10 of the puzzle and cut, as shown in FIG. 6.

A technological process for manufacturing the module is as follows:

Module technological process 1: SMT soldering of the top surface - SMT of the bottom surface - cleaning - packaging - curing - sanding (optional) - cutting (board division) - disposing a ball on the bottom surface (M-CP and M-BGA modules).

### (2) Structure and implementation when the system-in-a-package module 20 is soldered to the first circuit board 10

When the system-in-a-package module 20 is soldered to the first circuit board 10 by using a soldering end, the system-in-a-package module 20, the first component 40, and a nearby component (a third component 30) are soldered to a same surface of the first circuit board 10, to mount two layers of components on a single surface of the first circuit board 10.

When the system-in-a-package module 20 is mounted on the first circuit board 10, a height S between a concave cavity region of the system-in-a-package module 20 and the first circuit board 10 is within a range of 0.8 mm to 3 mm.

A component may or may not be mounted on a surface, away from the system-in-a-package module 20, of the first circuit board 10. When the component is mounted, three layers of components are mounted on the first circuit board 10. When the component is not mounted, the two layers of components are mounted on the single surface.

Compared with current mature packaging of the system-in-a-package module 20 or a component, the solution can have a standoff greater than 0.8 mm to mount the system-in-a-package module 20 on the first circuit board 10, and has a simple mounting process, high reliability, and good maintainability.

### Embodiment 2

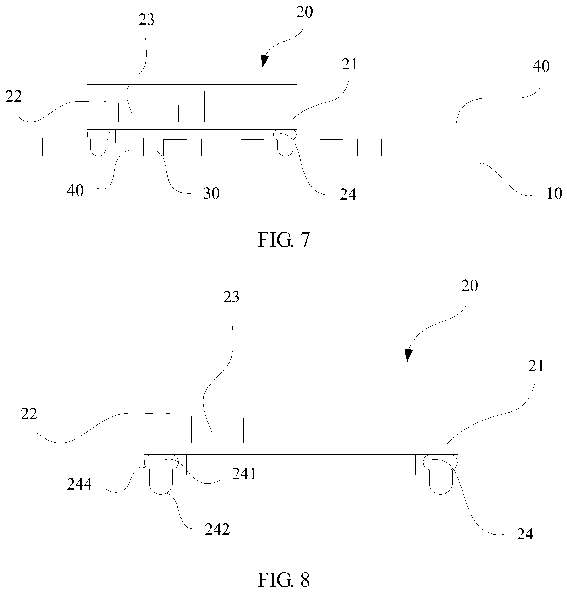

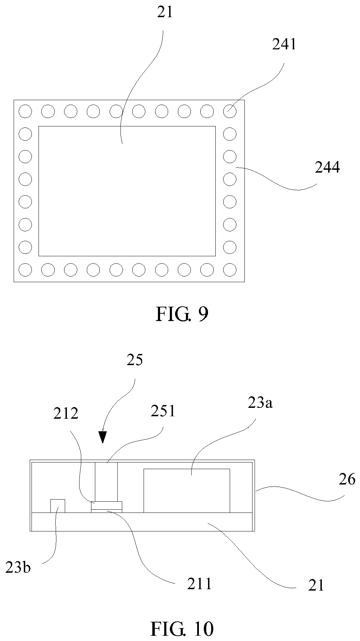

First, it should be noted that, a conductive terminal 24 appears in this embodiment as a part of structure of a system-in-a-package module 20. In this embodiment of this application, a first circuit board 10, a second circuit board 21, and a third circuit board 244 all are printed circuit boards. FIG. 7 is a schematic structural diagram of another board-level architecture according to this embodiment. FIG. 8 is a schematic structural diagram of a system-in-a-package module 20 of the board-level architecture shown in FIG. 7. FIG. 9 is a schematic structural diagram of conductive terminals 24 of the system-in-a-package module 20 shown in FIG. 8.

### (1) Module packaging structure and implementation thereof

A second component 23 is mounted on a top surface of the second circuit board 21. A quantity of second components 23 may be determined based on a requirement. There may be one second component 23, or may be two or more second components 23, which may be specifically determined based on an actual case. In addition, a component may also be mounted on a bottom surface of the second circuit board 21. In this way, components are disposed on two surfaces of the second circuit board 21, to reduce an area of the second circuit board 21.

In addition, the top surface of the second circuit board 21 is packaged to form a plastic package body 22 wrapping the second component 23, and a second solder ball 245 connected to an I/O terminal on the second circuit board 21 is packaged to form a plastic package layer 243 wrapping the second solder ball 245. When the plastic package body 22 and the plastic package layer 243 are formed, entire packaging or partial packaging may be performed, provided that the second component 23 and the second solder ball 245 can be wrapped. In addition, during specific disposition, a non-I/O terminal region on the bottom surface of the second circuit board 21 is not packaged, so that a space for accommodating a first component 40 is enclosed by the formed plastic package layer 243 and the bottom surface of the second circuit board 21. In other words, when the system-in-a-package module 20 is formed, a partial concave structure is formed on a surface of the module. A depth of the concave cavity relative to the first circuit board 10 is 0.8 mm to 3 mm.

When the second solder ball 245 is specifically disposed, an I/O terminal that is within packaging coverage of the bottom surface and that is on the PCB is connected to the second solder ball 245 through soldering, and the second solder ball 245 extends to a surface of the package of the bottom surface (a surface of the plastic package layer 243), to implement S-LGA packaging. In this case, the second solder ball 245 is electrically connected to the first circuit board 10 directly. Alternatively, a first solder ball 242 is disposed at a soldering end location of the second solder ball 245 to implement S-BGA packaging (as shown in FIG. 7). In this case, the system-in-a-package module 20 is connected to the first circuit board 10 by using the first solder ball 242.

A component may also be mounted on the bottom surface of the second circuit board 21, and the component may be exposed or covered by using a packaging material.

During specific disposition, a component of the second solder ball 245 may be any solder ball alloy component such as SnAgCu, SnAg, SnCu, SnBi, SnBiAg, or pure Sn.

In addition, second solder balls 245 may be arranged in one or more rows, or arranged randomly. There may be one or more concave cavities. As shown in FIG. 9, a structural form of the second solder balls 245 is similar to the manner of disposing the conductive columns 241 in Embodiment 1. Details are not described herein again.

Technological processes for manufacturing the module are as follows:
Technological process 1: SMT of the top surface - disposing a ball on the bottom surface - cleaning - packaging - curing -sanding - cutting and board division - sputter (optional) - disposing a ball on the bottom surface (during S-BGA).
Technological process 2: SMT of the top surface - cleaning - packaging of the top surface - curing - disposing a ball on the bottom surface - cleaning - packaging of the bottom surface - curing - sanding - cutting and board division - disposing a ball on the bottom surface (during S-BGA).

### (2) Structure and implementation when the system-in-a-package module 20 is soldered to the first circuit board 10

When the system-in-a-package module 20 is soldered to the first circuit board 10 by using a soldering end, the system-in-a-package module 20, the first component 40, and a nearby component are soldered to a same surface of the first circuit board 10, to mount two layers of components on a single surface of the PCB of the first circuit board 10.

When the system-in-a-package module 20 is mounted on the first circuit board 10, a height S between a concave cavity region of the system-in-a-package module 20 and the first circuit board 10 is within a range of 0.8 mm to 3 mm.

A component may or may not be mounted on a surface, away from the system-in-a-package module 20, of the first circuit board 10. When the component is mounted, three layers of components are mounted on the first circuit board 10. When the component is not mounted, the two layers of components are mounted on the single surface.

Compared with current mature packaging of the system-in-a-package module 20 or a component, the solution can have a standoff greater than 0.8 mm to mount the system-in-a-package module 20 on the first circuit board 10, and has a simple mounting process, high reliability, and good maintainability.

It can be learned from the foregoing description that, a difference between this embodiment and Embodiment 1 lies only in a conductor terminal change. To be specific, the conductive column 241 in Embodiment 1 is changed to the second solder ball 245 formed through soldering.

### Embodiment 3

First, it should be noted that, a conductive terminal 24 appears in this embodiment as a part of structure of a system-in-a-package module 20.

### (1) Module packaging structure and implementation thereof

A second component 23 is mounted on a top surface of the second circuit board 21. Entire packaging or partial packaging is performed to package the second component 23. In other words, a plastic package body 22 is formed. Alternatively, the second circuit board 21 may not be packaged. A packaging material or an underfill material is applied partially on a bottom surface of the second circuit board 21. The material completely covers a solder joint at which a conductive column 241 is soldered to the bottom surface of the second circuit board 21. The packaging material or the underfill material is not applied in a non-I/O terminal region on the bottom surface, to form a partial concave cavity on the bottom surface, to form an accommodation space 50. A height of a top surface of the concave cavity relative to a first circuit board 10 ranges from 0.8 mm to 3 mm. A conductor terminal that can be connected through soldering and that is on an I/O terminal that is within coverage of the package material or the underfill material applied on the bottom surface and that is on the second circuit board 21 extends outside the package material or the underfill material, to implement M-QFN packaging or U-QFN packaging. Alternatively, a first solder ball 242 is disposed at a soldering end location to implement M-CP packaging and U-CP packaging.

A difference between the system-in-a-package module 20 provided in this embodiment and that in Embodiment 1 lies only in different packaging structures used when the system-in-a-package module 20 is connected to the first circuit board 10. Other structures are all the same. Therefore, details are not described again.

It can be learned from the descriptions of Embodiment 1, Embodiment 2, and Embodiment 3 that, in the board-level architectures provided in the embodiments, each system-in-a-package module 20 in different solutions can be connected to the first circuit board 10, thereby achieving a simple mounting process, high reliability, and good maintainability. In addition, an area of the first circuit board 10 can be effectively reduced, thereby reducing an area of the entire board-level architecture, and facilitating miniaturization development of the board-level architecture.

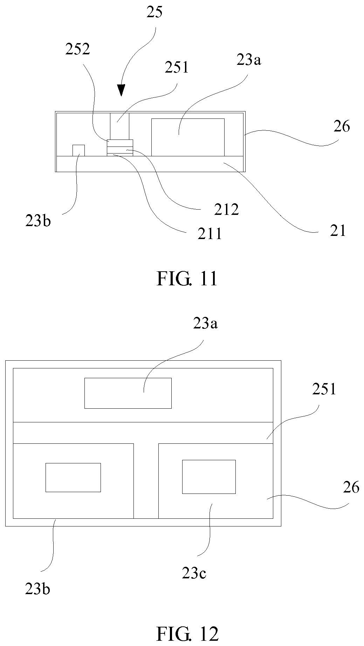

In addition, to improve a work environment of the second component 23, as shown in FIG. 10 to FIG. 12, the system-in-a-package module 20 provided in this embodiment further includes a metal shielding can 26 wrapping the plastic package body 22. The metal shielding can 26 is connected to a ground cable of the second circuit board 21. In this way, an electromagnetic isolation effect of the second component 23 in the system-in-a-package module 20 is improved, thereby improving a work effect of the second component 23. During specific disposition, when there are two or more second components 23, at least one isolating layer 25 is inserted in the plastic package body 22, and the at least one isolating layer 25 divides the metal shielding can 26 into at least two metal shielding spaces. The isolating layer 25 is a conductor, both an upper surface and side surfaces of the isolating layer 25 are electrically connected to the metal shielding can 26, a lower surface of the isolating layer 25 is electrically connected to the ground cable of the second circuit board 21, and the upper surface and the lower surface of the isolating layer 25 are opposite. There are a plurality of second components 23, and each metal shielding space has at least one second component 23 inside. FIG. 10 and FIG. 11 are schematic structural diagrams in which two second components 23: a second component 23a and a second component 23b are used. The isolating layer 25 divides the metal shielding can 26 into two electromagnetic shielding spaces, and the two second components 23a and 23b are respectively disposed in the two electromagnetic shielding spaces. As shown in FIG. 12, there are three second components 23: a second component 23a, a second component 23b, and a second component 23c, the isolating layer 25 divides the metal shielding can 26 into three electromagnetic shielding spaces, and the three second components 23a, 23b, and 23c each are located in one electromagnetic shielding space. In this way, an electromagnetic isolation effect of the second components 23 in the system-in-a-package module 20 is improved, thereby improving a work effect of the second components 23.

To ensure an electromagnetic shielding effect of the electromagnetic shielding space, connection effects between the metal shielding can 26 and the ground cable and between the isolating layer 25 and the ground cable need to be ensured. During specific disposition, solder exists on a solder pad 211 that is on the second circuit board 21 and that is connected to the ground cable, and the ground cable is electrically connected to the isolating layer 25 by using the solder. To ensure an electrical connection effect between the isolating layer 25 and the solder, and avoid that the solder is separated from the isolating layer 25 because the solder and the isolating layer 25 have different curing temperatures, different structures are used for the isolating layer 25 provided in this embodiment of this application, to ensure connection stability between the solder and the isolating layer 25. A detailed description is provided below by using specific embodiments.

### Embodiment 4

As shown in FIG. 10, the isolating layer 25 is a metal sheet 251, and one end of the metal sheet 251 is electrically connected to the metal shielding can 26, and the other end is electrically connected to the solder pad 211 that is on the second circuit board 21 and that is connected to the ground cable. During specific disposition, the isolating layer 25 may be one metal sheet 251. Specifically, both an upper surface and side surfaces of the metal sheet 251 are in contact with the metal shielding can 26, and a lower surface of the metal sheet 251 is in contact with the ground cable of the second circuit board 21.

In the foregoing solution, the metal sheet 251 is connected to the solder pad 211 by using solder 212, and the metal sheet 251 is not melted during soldering. Therefore, it can be ensured that the metal sheet 251 can be stably connected to the solder 212. The metal sheet 251 is exposed on a top surface of the plastic package body 22, and electrically connected to the metal shielding can 26. The metal sheet 251 and the metal shielding can 26 are separately connected to the ground cable to form ground loops, so that a plurality of electromagnetic shielding spaces can be formed.

The solder pad 211 and a ground copper line that is exposed on a side surface of the second circuit board 21 are in a same circuit, and metal layers (the metal shield can 26) on a same packaging surface form an overall same circuit, to implement partial electromagnetic shielding.

During specific disposition, to implement partial electromagnetic shielding, there are at least two cavities, as shown in FIG. 10; or there are a plurality of cavities, as shown in FIG. 12.

A material of the metal sheet 251 may be conductive metal such as copper alloy, or a non-conductive substrate whose surface is covered with a conductive coating.

A slot or a hole may be designed on the metal sheet 251. A size of the slot or an opening is determined based on a wavelength of an electromagnetic wave that needs to be shielded, to ensure an electromagnetic shielding effect.

### Embodiment 5

As shown in FIG. 11, the isolating layer 25 may alternatively include a metal sheet 251 and a cured conductive material 252. Specifically, a lower surface of the metal sheet 251 is in contact with the upper surface of the second circuit board 21, and the lower surface of the metal sheet 251 is electrically connected to the ground cable located on the upper surface of the second circuit board 21.

When a gap exists between an upper surface of the metal sheet 251 and an inner surface of the metal shielding can 26, a conductive material 252 such as silver paste may be applied on the upper surface of the metal sheet 251, to fill the gap between the upper surface of the metal sheet 251 and the inner surface of the metal shielding can 26. After the conductive material 252 is cured, the cured conductive material 252 is formed, so that the upper surface of the metal sheet 251 can be electrically connected to the inner surface of the metal shielding can 26 by using the cured conductive material 252.

When the silver paste is used as the conductive material, the metal sheet 251 is connected to the solder pad 211 by using solder 212, and the metal sheet 251 is not melted during soldering. Therefore, it can be ensured that the metal sheet 251 can be stably connected to the solder 212. The silver paste is poured on the metal sheet 251, to form a silver paste layer. The silver paste layer is exposed on a top surface of the plastic package body 22, and electrically connected to the metal shielding can 26. In this case, the metal sheet 251 and the silver paste layer jointly form the isolating layer 25. The metal sheet 251, the silver paste layer, and the metal shielding can 26 are separately connected to the ground cable to form ground loops, so that a plurality of electromagnetic shielding spaces can be formed.

The solder pad 211 and a ground copper line that is exposed on a side surface of the second circuit board 21 are in a same circuit, and metal layers on a same packaging surface form an overall same circuit, to implement partial electromagnetic shielding.

During specific disposition, to implement partial electromagnetic shielding, there are at least two cavities, as shown in FIG. 11; or there are a plurality of cavities, as shown in FIG. 12.

A material of the metal sheet 251 may be conductive metal such as copper alloy, or a non-conductive substrate whose surface is covered with a conductive coating.

A slot or a hole may be designed on the metal sheet 251. A size of the slot or an opening is determined based on a wavelength of an electromagnetic wave that needs to be shielded, to ensure an electromagnetic shielding effect.

It can be learned from the descriptions of Embodiment 3 and Embodiment 4 that, in the shielding structures provided in the embodiments, the solder 212 is used for soldering to the metal sheet 251, so that connection stability between the isolating layer 25 and the solder 212 is ensured, thereby ensuring an electromagnetic shielding effect of the formed electromagnetic shielding space.

In addition, it can be learned from the foregoing structure description of the board-level architecture that, the embodiments of this application further provide a method for manufacturing a board-level architecture. The manufacturing method includes:
disposing at least one first component 40 on an upper surface of a first circuit board 10;
connecting a conductive terminal 24 onto a system-in-a-package module 20, where the conductive terminal 24 is electrically connected to a lower surface of the system-in-a-package module 20; and
electrically connecting the conductive terminal 24 to the upper surface of the first circuit board 10, where the at least one first component 40 is isolated from the conductive terminal 24 during connection, and the conductive terminal 24 is electrically connected to the upper surface of the first circuit board 10; and when the conductive terminal 24 is connected to the first circuit board 10, a vertical projection of the system-in-a-package module 20 on the upper surface of the first circuit board 10 along a thickness direction of the first circuit board 10 is located within the upper surface of the first circuit board 10, and the first component 40 disposed on the upper surface of the first circuit board 10 is located in a region between the lower surface of the system-in-a-package module 20 and the upper surface of the first circuit board 10.

In the foregoing technical solution, a plurality of components are packaged by using the system-in-a-package module 20 to be connected to the first circuit board 10, so that spaces occupied by the components can be effectively integrated. In addition, when the system-in-a-package module 20 is connected to the first circuit board 10, an accommodation space 50 is formed between the system-in-a-package module 20 and the first circuit board 10, so that the relatively small first component 40 can be placed in the accommodation space 50, to stack, on the first board-level architecture, components laid flat on the first circuit board 10 in the prior art, to reduce an area occupied by the components on the first circuit board 10, thereby reducing a size of the board-level architecture, and facilitating miniaturization development of the board-level architecture.

Specific manufacturing includes the following steps.

Step 1: Manufacture the system-in-a-package module 20.

At least two second components 23 are disposed on a second circuit board 21. Every two second components 23 are isolated from each other, and a vertical projection of the second circuit board 21 on the upper surface of the first circuit board 10 along the thickness direction of the first circuit board 10 is located within the upper surface of the first circuit board 10.

At least a side surface of each second component 23 is packaged by using a plastic package body 22.

In a specific implementation solution, the method further includes wrapping a side surface of the conductive terminal by using a plastic package layer 243; or
disposing a third circuit board 244 on the upper surface of the first circuit board 10, where the third circuit board 244 has a through hole, the disposed conductive terminal passes through the through hole, and a vertical projection of the disposed third circuit board 244 on a lower surface of the second circuit board 21 is located within the lower surface of the second circuit board 21.

The formed plastic package body 22 is wrapped by using a metal shielding can 26, and the metal shielding can 26 is electrically connected to a ground cable of the second circuit board 21.

In a specific implementation solution, the manufacturing the system-in-a-package module further includes the following step:
forming at least one isolating layer 25 inserted in the plastic package body 22, where the at least one isolating layer 25 divides the metal shielding can 26 into at least two metal shielding spaces, the isolating layer 25 is a conductor, both an upper surface and side surfaces of the isolating layer 25 are electrically connected to the metal shielding can 26, a lower surface of the isolating layer 25 is electrically connected to the ground cable of the second circuit board 21, the upper surface and the lower surface of the isolating layer 25 are opposite, there are a plurality of second components 23, and each metal shielding space has at least one second component 23 inside.

Specific manufacturing of the isolating layer 25 includes the following steps:
soldering a metal sheet 251 to a solder pad connected to the ground cable of the second circuit board 21;
forming the plastic package body 22, where the plastic package body 22 wraps the metal sheet 251;
opening a slot in the plastic package body 22 to expose the metal sheet 251; and
pouring silver paste into the opened slot to form a conductive material 252 connected to the metal sheet 251, so that the metal sheet 251 and the conductive material 252 form the isolating layer 25. An isolated ground effect of the isolating layer 25 is further improved, thereby improving an electromagnetic isolation effect.

Step 2: Connect the conductive terminal 24 onto the system-in-a-package module 20, where the conductive terminal 24 is electrically connected to the lower surface of the system-in-a-package module 20; and electrically connect the conductive terminal 24 to the upper surface of the first circuit board 10, where the at least one first component 40 is isolated from the conductive terminal 24 during connection, and the conductive terminal 24 is electronically connected to the upper surface of the first circuit board 10; and when the conductive terminal 24 is connected to the first circuit board 10, the vertical projection of the system-in-a-package module 20 on the upper surface of the first circuit board 10 along the thickness direction of the first circuit board 10 is located within the upper surface of the first circuit board 10, and the first component 40 disposed on the upper surface of the first circuit board 10 is located in the region between the lower surface of the system-in-a-package module 20 and the upper surface of the first circuit board 10.

Specifically, the conductive terminal 24 is connected to the first circuit board 10 through soldering by using a first solder ball 242.

It can be learned from the foregoing description that, a plurality of components are packaged by using the system-in-a-package module to be connected to the first circuit board, so that spaces occupied by the components can be effectively integrated. In addition, when the system-in-a-package module is connected to the first circuit board, an accommodation space is formed between the system-in-a-package module and the first circuit board, so that the relatively small first component can be placed in the accommodation space, to stack, on the first board-level architecture, components laid flat on the first circuit board in the prior art, to reduce an area occupied by the components on the first circuit board, thereby reducing a size of the board-level architecture, and facilitating miniaturization development of the board-level architecture.

Obviously, a person skilled in the art can make various modifications and variations to this application without departing from the spirit and scope of this application. This application is intended to cover these modifications and variations of this application provided that they fall within the scope of the claims of this application and their equivalent technologies.

## Claims

1. A board-level architecture, comprising: a first circuit board, a system-in-a-package module, at least one conductive terminal, and at least one first component, wherein the system-in-a-package module is fastened on an upper surface of the first circuit board, a lower surface of the system-in-a-package module faces the upper surface of the first circuit board, and a vertical projection of the system-in-a-package module on the upper surface of the first circuit board along a thickness direction of the first circuit board is located within the upper surface of the first circuit board;
the conductive terminal is located between the lower surface of the system-in-a-package module and the upper surface of the first circuit board, and one end of the conductive terminal is electrically connected to the lower surface of the system-in-a-package module, and the other end is electrically connected to the upper surface of the first circuit board; and
the first component is fastened on the upper surface of the first circuit board, the first component is located in a region between the lower surface of the system-in-a-package module and the upper surface of the first circuit board, and the first component is isolated from the conductive terminal.

2. The board-level architecture according to claim 1, wherein the system-in-a-package module comprises a second circuit board, a plastic package body, and at least two second components, each second component is fastened on an upper surface of the second circuit board, every two second components are isolated from each other, at least a side surface of each second component is wrapped by the plastic package body, and a vertical projection of the second circuit board on the upper surface of the first circuit board along the thickness direction of the first circuit board is located within the upper surface of the first circuit board.

3. The board-level architecture according to claim 1 or 2, wherein the one end of the conductive terminal is electrically connected to a lower surface of the second circuit board, and the lower surface of the second circuit board is away from the upper surface of the second circuit board.

4. The board-level architecture according to claim 3, wherein the other end of the conductive terminal is electrically connected to the upper surface of the first circuit board by using a first solder ball.

5. The board-level architecture according to any one of claims 1 to 4, wherein the conductive terminal is a conductive column or a second solder ball.

6. The board-level architecture according to any one of claims 3 to 5, wherein a side surface of the conductive terminal is wrapped by a plastic package layer.

7. The board-level architecture according to any one of claims 3 to 5, further comprising a third circuit board, wherein the third circuit board is located between the first circuit board and the second circuit board, and a vertical projection of the third circuit board on the lower surface of the second circuit board along a thickness direction of the third circuit board is located within the lower surface of the second circuit board; and
the third circuit board has a through hole, and the conductive terminal passes through the through hole.

8. The board-level architecture according to any one of claims 2 to 7, wherein there are two or more conductive terminals, at least one of the two or more conductive terminals is electrically connected to a first edge of the lower surface of the second circuit board, at least one of the two or more conductive terminals is electrically connected to a second edge of the lower surface of the second circuit board, and the first edge is opposite or adjacent to the second edge.

9. The board-level architecture according to any one of claims 2 to 8, wherein the system-in-a-package module further comprises a metal shielding can wrapping the plastic package body, and the metal shielding can is connected to a ground cable of the second circuit board.

10. The board-level architecture according to claim 9, wherein at least one isolating layer is inserted in the plastic package body, the at least one isolating layer divides the metal shielding can into at least two metal shielding spaces, the isolating layer is a conductor, both an upper surface and side surfaces of the isolating layer are electrically connected to the metal shielding can, a lower surface of the isolating layer is electrically connected to the ground cable of the second circuit board, and the upper surface and the lower surface of the isolating layer are opposite; and
there are a plurality of second components, and each metal shielding space has at least one second component inside.

11. A method for manufacturing a board-level architecture, comprising the following steps:
disposing at least one first component on an upper surface of a first circuit board;
connecting a conductive terminal onto a system-in-a-package module, wherein the conductive terminal is electrically connected to a lower surface of the system-in-a-package module; and
electrically connecting the conductive terminal to the upper surface of the first circuit board, wherein the at least one first component is isolated from the conductive terminal during connection; and when the conductive terminal is connected to the first circuit board, a vertical projection of the system-in-a-package module on the upper surface of the first circuit board along a thickness direction of the first circuit board is located within the upper surface of the first circuit board, and the first component disposed on the upper surface of the first circuit board is located in a region between the lower surface of the system-in-a-package module and the upper surface of the first circuit board.

12. The method for manufacturing a board-level architecture according to claim 11, further comprising manufacturing the system-in-a-package module, and the manufacturing the system-in-a-package module comprises the following steps:
disposing at least two second components on a second circuit board, wherein every two second components are isolated from each other, and a vertical projection of the second circuit board on the upper surface of the first circuit board along the thickness direction of the first circuit board is located within the upper surface of the first circuit board; and
packaging at least a side surface of each second component by using a plastic package body.

13. The method for manufacturing a board-level architecture according to claim 11, further comprising wrapping a side surface of the conductive terminal by using a plastic package layer; or
disposing a third circuit board on the upper surface of the first circuit board, wherein the third circuit board has a through hole, the disposed conductive terminal passes through the through hole, and a vertical projection of the disposed third circuit board on a lower surface of the second circuit board is located within the lower surface of the second circuit board.

14. The method for manufacturing a board-level architecture according to claim 12 or 13, wherein the manufacturing the system-in-a-package module further comprises the following step:
wrapping the formed plastic package body by using a metal shielding can, wherein the metal shielding can is electrically connected to a ground cable of the second circuit board.

15. The method for manufacturing a board-level architecture according to claim 14, wherein the manufacturing the system-in-a-package module further comprises the following step:
forming at least one isolating layer inserted in the plastic package body, wherein the at least one isolating layer divides the metal shielding can into at least two metal shielding spaces, the isolating layer is a conductor, both an upper surface and side surfaces of the isolating layer are electrically connected to the metal shielding can, a lower surface of the isolating layer is electrically connected to the ground cable of the second circuit board, the upper surface and the lower surface of the isolating layer are opposite, there are a plurality of second components, and each metal shielding space has at least one second component inside.
